# EUROPEAN PATENT APPLICATION

(11) **EP 2 278 626 A1**
(43) Date of publication of application: **26.01.2011**
(21) Application number: 09731607.9
(22) Date of filing: 13.04.2009
(51) Int. Cl.: H01L 31/042

(54) **TRACKING-TYPE PHOTOVOLTAIC POWER GENERATION DEVICE**

(30) Priority: 17.04.2008 JP 2008107997
(71) Applicant: Sharp Kabushiki Kaisha, Osaka-shi, Osaka 545-8522 (JP)
(72) Inventor: YOSHIDA, Hiroyuki, Osaka 545-8522 (JP); TANAKA, Masao, Osaka 545-8522 (JP)
(74) Representative: Müller - Hoffmann & Partner
(86) International application number: PCT/JP2009/057440
(87) International publication number: WO 2009/128422

(57) **Abstract**

According to an embodiment, a tracking drive type solar power generation apparatus (1) includes a tracking control portion (20) having a tilt drive portion (21) that controls the tilt position of a module panel (10) (a driving solar cell module (12) and juxtaposition solar cell modules (13) supported by main beam members 22), a swivel drive portion (25) that controls the swivel position of the module panel (10), and a tracking control base (20c) to which the tilt drive portion (21) and the swivel drive portion (25) are integrally connected. The driving solar cell module (12) includes, in a middle thereof in a length direction, inside a bottom plate portion (14b) thereof, a tilt drive housing portion (17) in which the tilt drive portion (21) is housed. A tilt rotation axis (21s) serving as the center of rotation of the tilt drive portion (21) is disposed on the same side with respect to the bottom plate portion (14b) as the center of gravity (CG) of the driving solar cell module (12).

## Description

### Technical Field

The present invention relates to a tracking drive type solar power generation apparatus including a module panel in which solar cells are arranged and a tracking control portion that drives the module panel to track the sun.

### Background Art

Solar power generation apparatuses that convert solar energy into electric power are known. Moreover, since such apparatuses do not need fossil fuels and the like and have almost no environmental impact, development of a high-power solar power generation apparatus has been pursued. Furthermore, in order to increase the power generation capacity to generate high power, tracking drive type solar power generation apparatuses that track the path of the sun (determined by the altitude and azimuth of the sun) and rotate (tracking drive) a module panel in which solar cells are arranged have been proposed (for example, see Patent Documents 1 to 3).

In particular, in the case of concentrating solar power generation apparatuses that use condenser lenses, solar tracking drive (tracking concentration) makes it possible to direct concentrated sunlight at right angles to the light-receiving surfaces of the solar cells and therefore has the advantage that the power generation efficiency can be significantly improved. In view of this merit, concentrating solar power generation apparatuses (tracking drive type solar power generation apparatuses) that use condenser lenses are becoming used in regions where installation over a large area is possible and other regions as reasonable power supply means.

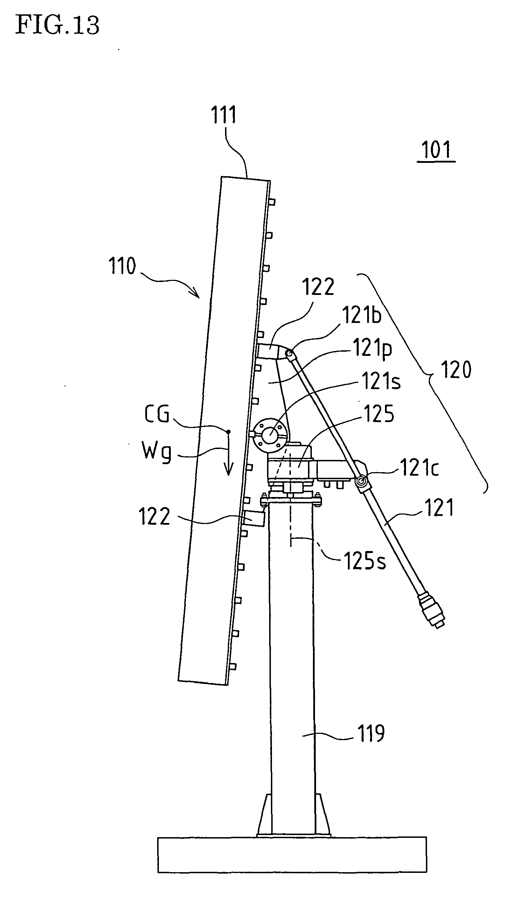

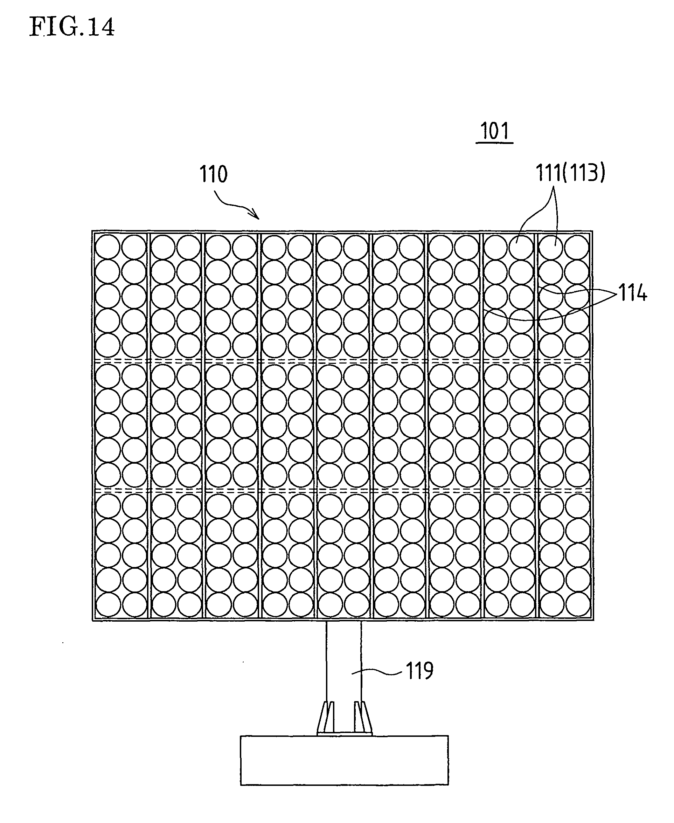

A conventional tracking drive type solar power generation apparatus will be described based on Figs. 13 and 14.

Fig. 13 is a side view of a conventional tracking drive type solar power generation apparatus. Fig. 14 is a front view of the tracking drive type solar power generation apparatus shown in Fig. 13.

A tracking drive type solar power generation apparatus 101 includes a module panel 110 in which solar cells (not shown) are arranged and a tracking control portion 120 that is installed on a rear face of the module panel 110 and that orients the module panel 110 toward the sun for solar tracking.

The module panel 110 is formed by juxtaposing a plurality of solar cell modules 111 (juxtaposition solar cell modules 113) on which solar cells are mounted. Each solar cell module 111 includes an elongated module casing 114. A plurality of solar cell modules 111 elongated in a vertical direction are juxtaposed in a horizontal direction, and bottom plate portions thereof are supported and fixed by main beam members 122 extending in the horizontal direction.

A tracking control portion 120 includes a tilt drive portion 121 (a power cylinder) that controls a tilt position of the module panel 110 and a swivel drive portion 125 (a worm reducer) that controls a swivel position of the module panel 110. The tilt drive portion 121 adjusts the module panel 110 to the altitude of the sun, and the swivel drive portion 125 adjusts the module panel 110 to the azimuth of the sun.

The swivel drive portion 125 is installed on a top face (a flange face) of a support pole 119 and performs swivel control to swivel the module panel 110 around a swivel rotation axis 125s in the horizontal direction.

The tilt drive portion 121 is engaged with a tilt rotation axis 121s via a support plate 121p provided on the outside of the rear face of the solar cell modules 111 and connected to the main beam members 122. The tilt drive portion 121 performs tilt control to tilt the module panel 110 around the tilt rotation axis 121s in the vertical direction.

It should be noted that the tilt position of the module panel 110 can be controlled by controlling the distance between a tilt fulcrum 121b connected to the main beam member 122 disposed on an upper side and a tilt control fulcrum 121c by means of the tilt drive portion 121.

In the conventional tracking drive type solar power generation apparatus 101, the tilt drive portion 121 and the swivel drive portion 125 also have totally different operation mechanisms and are thus assembled separately, and furthermore, the tilt drive portion 121 and the tilt rotation axis 121s are disposed in mutually different positions. Accordingly, the tracking control portion 120 has a large structure, complicating the assembly process, and thus, there are the problems of low productivity (ease of assembly, ease of attachment) and the resultant high cost.

Moreover, the tilt drive portion 121 is disposed with the tilt rotation axis 121s being exposed to the outside of the bottom plate portions of the module panel 110 (the solar cell modules 111). That is to say, tilt control is performed at a distance from the center of gravity CG of the module panel 110. Therefore, gravity Wg at the center of gravity CG acts on the tilt drive portion 121 as a rotating torque, and accordingly, a large tilting torque is required to control the tilt position of the solar cell modules 111. That is to say, it is necessary to increase the capacity and size of the tilt drive portion 121, leading to the problem of an increase in the cost of the tilt drive portion 121. Moreover, a large driving power required to drive the tilt drive portion 121 necessitates a large operating power, which reduces the operating efficiency, leading to the problem of high operating cost.

### Related Art Documents

### Patent Documents

Patent Document 1: JP 2002-202817A
Patent Document 2: JP 2007-19331A
Patent Document 3: JP 2007-103713A

### Disclosure of the Invention

### Problem to be Solved by the Invention

According to the present invention, a tracking drive type solar power generation apparatus including a module panel in which solar cells are arranged and a tracking control portion that drives the module panel to track the sun further includes a tilt drive portion that rotates the module panel around a tilt rotation axis that is disposed on the same side with respect to a bottom plate portion of the module panel as the center of gravity of the module panel, thereby reducing the driving torque that is necessary in controlling the tilt position of the module panel, reducing the size, power consumption, and cost of the tilt drive portion, and providing an inexpensive tracking drive type solar power generation apparatus having excellent reliability and operating efficiency.

### Means for Solving the Problem

A tracking drive type solar power generation apparatus according to the present invention is a tracking drive type solar power generation apparatus including a module panel in which solar cells are arranged and a tracking control portion that drives the module panel to track the sun, wherein the tracking control portion includes a tilt drive portion that controls a tilt position of the module panel and a swivel drive portion that controls a swivel position of the module panel, and the tilt drive portion rotates the module panel around a tilt rotation axis that is disposed on the same side with respect to a bottom plate portion of the module panel as a center of gravity of the module panel.

With this configuration, the tilt rotation axis can be positioned closer to the center of gravity of the module panel with respect to the bottom plate portion of the module panel, so that the driving torque that is necessary in controlling the tilt position of the module panel can be reduced, and therefore, the size, power consumption, and cost of the tilt drive portion can be reduced and an inexpensive tracking drive type solar power generation apparatus having excellent reliability and operating efficiency can be provided.

Moreover, in the tracking drive type solar power generation apparatus according to the present invention, the tilt rotation axis may be positioned so as to coincide with the center of gravity of the module panel.

With this configuration, the driving torque that is necessary for control of the tilt position can be minimized, and accordingly, the reliability and the operating efficiency can be improved even more.

Moreover, in the tracking drive type solar power generation apparatus according to the present invention, the tracking control portion may include a tracking control base to which the tilt drive portion and the swivel drive portion are integrally connected.

With this configuration, the tilt drive portion and the swivel drive portion can be integrated into a single unit, and accordingly, the tracking control portion can have a smaller, simplified, and higher-precision structure, making it possible to facilitate assembly to the module panel and the support pole, so that the cost and installation man-hours of the tracking control portion can be reduced and an inexpensive tracking drive type solar power generation apparatus having excellent reliability and operating efficiency can be provided.

Moreover, in the tracking drive type solar power generation apparatus according to the present invention, the module panel may include an elongated driving solar cell module that is disposed in a middle of the module panel in a horizontal direction, elongated juxtaposition solar cell modules that are disposed on both sides of the driving solar cell module, and main beam members that support bottom plate portions of the driving solar cell module and the juxtaposition solar cell modules, and the driving solar cell module includes, in a middle of a module casing in a length direction, inside a bottom face thereof, a tilt drive housing portion in which the tilt drive portion is housed.

With this configuration, positioning of the tilt rotation axis with respect to the center of gravity of the module panel can be performed easily and with high accuracy and the tilt drive portion protected by the tilt drive housing portion, so that the arrangement density of the solar cells in the module panel can be increased, and furthermore, a load due to the module panel can be applied to the tilt drive portion in a balanced manner, making the tilt drive portion capable of performing tilt control easily and with high accuracy and hence highly reliable.

Moreover, in the tracking drive type solar power generation apparatus according to the present invention, the module panel may include a tilt drive disposition portion in which the tilt drive portion is located in a middle of the module panel in a horizontal direction, elongated juxtaposition solar cell modules that are disposed on both sides of the tilt drive disposition portion, and main beam members that support bottom plate portions of the juxtaposition solar cell modules.

With this configuration, the tilt drive portion can be disposed easily and with high accuracy, so that a load due to the module panel can be applied to the tilt drive portion in a balanced manner, making the tilt drive portion capable of performing tilt control easily and with high accuracy and hence highly reliable.

Moreover, in the tracking drive type solar power generation apparatus according to the present invention, the tilt drive portion may include a pair of connecting plates that are connected to each other by the two main beam members and disposed corresponding to side plate portions in a length direction of the juxtaposition solar cell modules, and a rotary driver that is disposed between the connecting plates and between the main beam members and fixed to the connecting plates and that rotates the connecting plates around the tilt rotation axis.

With this configuration, the connecting plates are rotated easily and with high accuracy to tilt the pair of main beam members easily and with high accuracy, so that the tilt position of the module panel can be controlled easily and with high accuracy, making the tilt drive portion mechanically stable with a simple structure and hence highly reliable.

### Effects of the Invention

A tracking drive type solar power generation apparatus according to the present invention is a tracking drive type solar power generation apparatus including a module panel in which solar cells are arranged and a tracking control portion that drives the module panel to track the sun, wherein the tracking control portion includes a tilt drive portion that controls a tilt position of the module panel and a swivel drive portion that controls a swivel position of the module panel, and the tilt drive portion rotates the module panel around a tilt rotation axis that is disposed on the same side with respect to a bottom plate portion of the module panel as the center of gravity of the module panel. Thus, the tilt rotation axis can be positioned closer to the center of gravity of the module panel with respect to the bottom plate portion of the module panel, and accordingly, the driving torque that is necessary in controlling the tilt position of the module panel can be reduced, so that it is possible to obtain an effect that the size, power consumption, and cost of the tilt drive portion can be reduced and an inexpensive tracking drive type solar power generation apparatus having excellent reliability and operating efficiency can be provided.

### Brief Description of Drawings

Fig. 1 is a rear perspective view showing a tracking drive type solar power generation apparatus according to Embodiment 1 of the present invention as viewed from a rear side.
Fig. 2 is an exploded perspective view showing a driving solar cell module constituting a module panel of the tracking drive type solar power generation apparatus according to Embodiment 1 of the present invention in an exploded manner.
Fig. 3 is an exploded perspective view showing a juxtaposition solar cell module constituting the module panel of the tracking drive type solar power generation apparatus according to Embodiment 1 of the present invention in an exploded manner.
Fig. 4 is a schematic side view conceptually showing a tilt drive portion and a swivel drive portion that constitute a tracking control portion of the tracking drive type solar power generation apparatus according to Embodiment 1 of the present invention as viewed from a lateral side.
Fig. 5 is a schematic plan view conceptually showing a positional relationship between the driving solar cell module and the juxtaposition solar cell modules around the tilt drive portion shown in Fig. 4, as viewed from the direction of arrow VV of Fig. 4.
Fig. 6 is a schematic rear view conceptually showing the positional relationship between the driving solar cell module and the juxtaposition solar cell modules around the tilt drive portion shown in Fig. 4, as viewed from the direction of arrow HH of Fig. 4.
Fig. 7 is a schematic end view conceptually showing a positional relationship between solar cells arranged in the solar cell module shown in Fig. 6 and a module casing as viewed from a direction intersecting with a main beam member.
Fig. 8 is a schematic rear view showing a positional relationship between solar cell modules of a tracking drive type solar power generation apparatus according to Embodiment 2 of the present invention as compared with that in the case of Fig. 6.

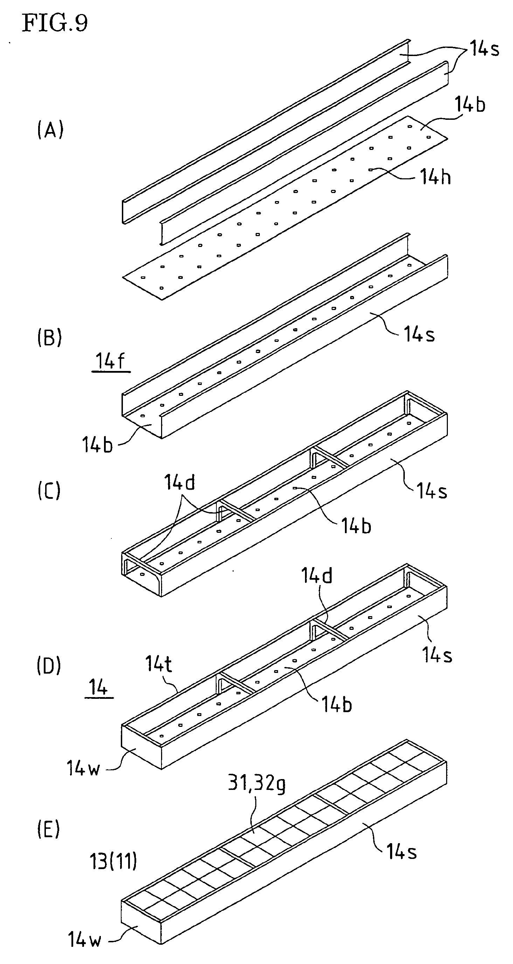

Fig. 9 illustrates an assembly process of a juxtaposition solar cell module and a module casing according to Embodiment 3 of the present invention by means of perspective views, where Fig. 9(A) shows side plate portions and a bottom plate portion that have been prepared, Fig. 9(B) shows a frame formed by connecting the side plate portions to the bottom plate portion, Fig. 9(C) shows a state in which partition plates have been connected to the frame, Fig. 9(D) shows a state in which sealing plates have been attached to both ends of the frame, and Fig. 9(E) shows a state in which translucent protective plates and condenser lenses have been disposed on the top of the side plate portions.
Fig. 10 is an exploded perspective view showing a tracking drive type solar power generation apparatus according to Embodiment 3 of the present invention in an exploded manner.
Fig. 11 illustrates external views schematically showing an appearance of a tracking drive type solar power generation apparatus according to Embodiment 4 of the present invention, where Fig. 11(A) is a front view, and Fig. 11(B) is a side view as viewed from the direction of arrow B of Fig. 11(A).
Fig. 12 is a schematic side view conceptually showing a tilt drive portion and a swivel drive portion that constitute a tracking control portion of a tracking drive type solar power generation apparatus according to a variation of Embodiment 4 of the present invention, as viewed from a lateral side.
Fig. 13 is a side view of a conventional tracking drive type solar power generation apparatus.
Fig. 14 is a front view of the tracking drive type solar power generation apparatus shown in Fig. 13.

### Best Mode for Carrying Out the Invention

Hereinafter, embodiments of the present invention will be described based on the drawings.

### Embodiment 1

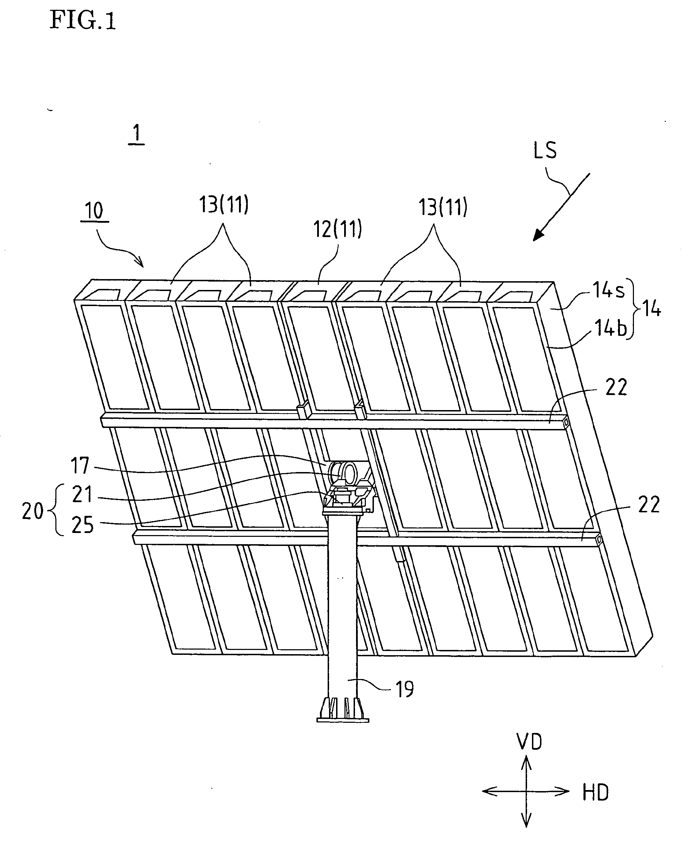

A tracking drive type solar power generation apparatus according to the present embodiment will be described based on Figs. 1 to 7.

Fig. 1 is a rear perspective view showing the tracking drive type solar power generation apparatus according to Embodiment 1 of the present invention as viewed from a rear side.

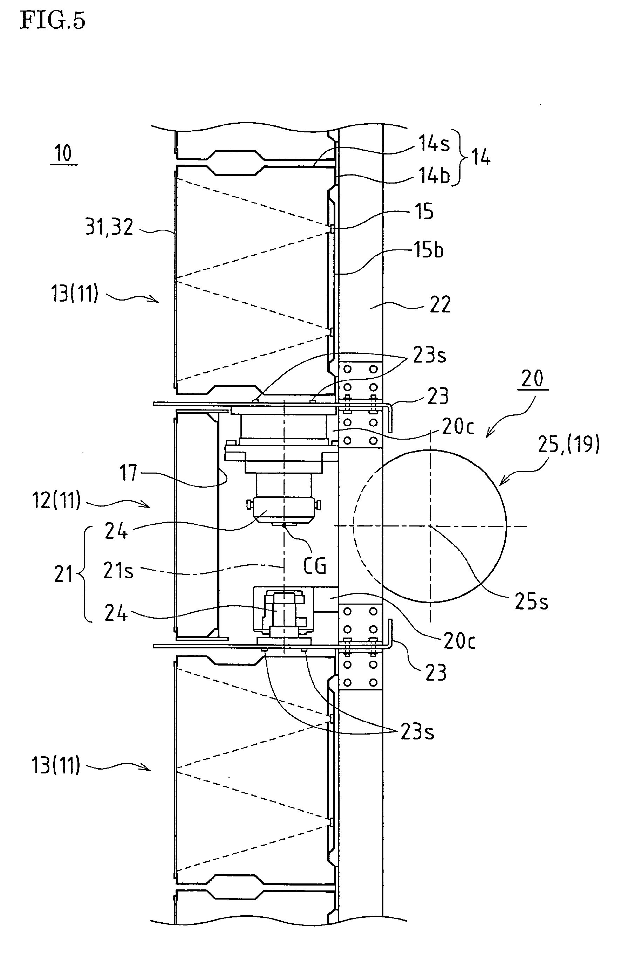

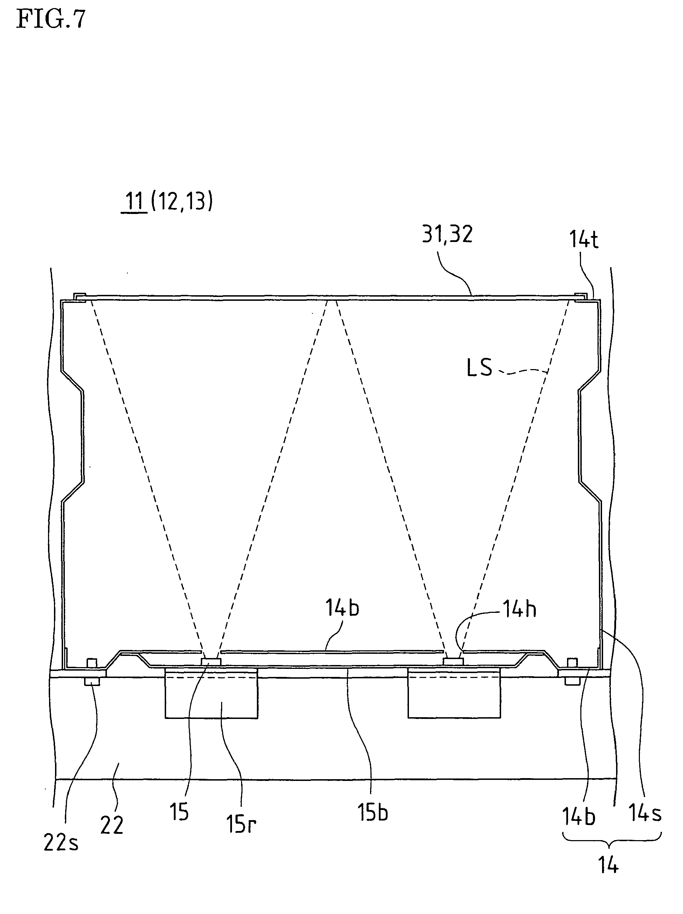

A tracking drive type solar power generation apparatus 1 according to the present embodiment includes a module panel 10 in which solar cells 15 (see Figs. 5 and 7) are arranged and a tracking control portion 20 that drives the module panel 10 to track the sun. The tracking control portion 20 includes a tilt drive portion 21 that controls a tilt position of the module panel 10 and a swivel drive portion 25 that controls a swivel position of the module panel 10. The tilt drive portion 21 tracks the altitude of the sun, and the swivel drive portion 25 tracks the azimuth of the sun.

Moreover, the tracking control portion 20 is attached to a flange face of a support pole 19 that is installed upright in a vertical direction VD, which is perpendicular to a horizontal direction HD. Therefore, the tracking control portion 20 can track the sun (sunlight LS) to orient the module panel 10 toward sunlight LS.

The module panel 10 includes an elongated driving solar cell module 12 disposed in the middle of the module panel 10 in the horizontal direction HD, elongated juxtaposition solar cell modules 13 disposed on both sides of the driving solar cell module 12, and main beam members 22 that support bottom plate portions 14b of the driving solar cell module 12 and the juxtaposition solar cell modules 13. In the present embodiment, the module panel 10 is constituted by one driving solar cell module 12 and, for example, eight juxtaposition solar cell modules 13.

The driving solar cell module 12 and the juxtaposition solar cell modules 13 (hereinafter may be simply referred to as solar cell modules 11 if there is no need to distinguish between the driving solar cell module 12 and the juxtaposition solar cell modules 13) each have a module casing 14 constituted by side plate portions 14s and the bottom plate portion 14b. As described above, the module casing 14 is elongated in the vertical direction and is structurally stable by being supported by the two main beam members 22 extending in the horizontal direction.

The driving solar cell module 12 includes, in the middle thereof in a length direction (the vertical direction VD), inside the bottom plate portion 14b thereof, a tilt drive housing portion 17 in which the tilt drive portion 21 is housed. In the driving solar cell module 12, the solar cells 15 can be disposed in positions outside the tilt drive housing portion 17.

That is to say, in the module panel 10 according to the present embodiment, since the driving solar cell module 12 on which the solar cells 15 are mounted is disposed in the middle, the arrangement density of the solar cells 15 in the module panel 10 can be increased as compared with that of Embodiment 2 that will be described later.

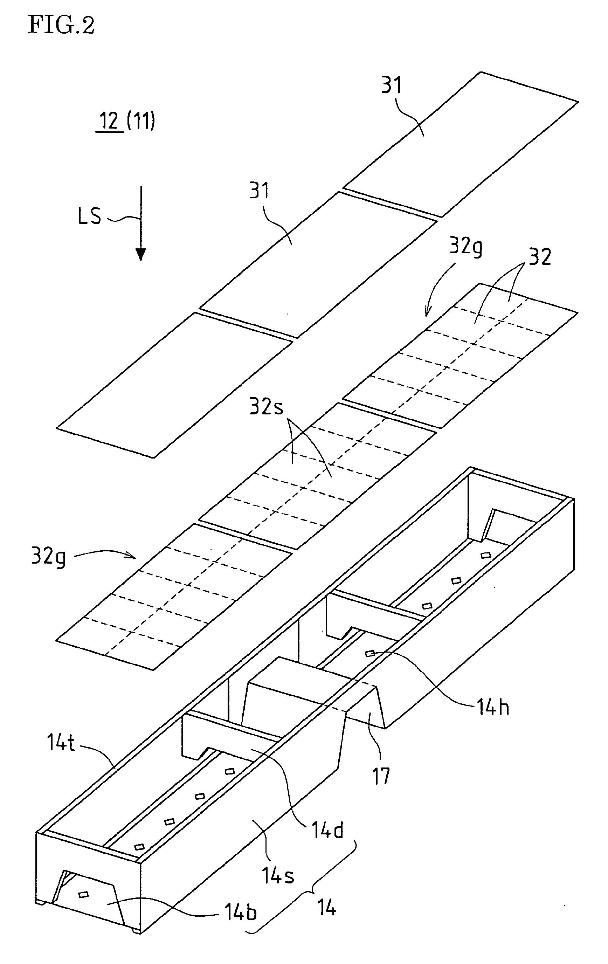

Fig. 2 is an exploded perspective view showing the driving solar cell module constituting the module panel of the tracking drive type solar power generation apparatus according to Embodiment 1 of the present invention in an exploded manner.

The driving solar cell module 12 includes the module casing 14 having the side plate portions 14s, the bottom plate portion 14b, and partition plates 14d. The side plate portions 14s form side faces in an elongation direction. The bottom plate portion 14b forms a bottom face in the elongation direction. The partition plates 14d improve mechanical strength and positioning accuracy of the side plate portions 14s.

The bottom plate portion 14b has sunlight transmission holes 14h for irradiating sunlight LS onto the respective solar cells 15. A lamination of a translucent protective plate 31 on the outside and condenser lenses 32 on the inside is disposed on a top portion 14t of the module casing 14 where sunlight LS enters.

The translucent protective plate 31 is formed of, for example, a glass plate, and protects the solar cells 15 from the external environment and holds the condenser lenses 32. The condenser lenses 32 are Fresnel lenses formed of, for example, an acrylic resin, and have a function of concentrating sunlight LS toward the respective solar cells 15.

A mount board 15b (see Figs. 5 and 7) on which the solar cells 15 are mounted is disposed on a back face of the bottom plate portion 14b. Therefore, sunlight LS that has been concentrated by the condenser lenses 32 can be irradiated onto the solar cells 15 through the respective sunlight transmission holes 14h.

Ten (two rows x five) condenser lenses 32 are arranged for a single translucent protective plate 31. In other words, ten solar cells 15 can be arranged for a single translucent protective plate 31. The ten (two rows x five) condenser lenses 32 constitute a condenser lens group 32g.

Three translucent protective plates 31 and three condenser lens groups 32g are disposed on a single module casing 14. Therefore, the positions of the condenser lenses 32 can be accurately adjusted even to an error or a change that may occur in the length direction of the module casing 14.

Moreover, ends of each of the three translucent protective plates 31 and three condenser lens groups 32g are supported on the partition plates 14d. Therefore, the partition plates 14d can improve the mechanical strength of the translucent protective plates 31 and the condenser lens groups 32g as well as improving the position accuracy of the side plate portions 14s (the module casing 14).

The driving solar cell module 12 according to the present embodiment includes, in the middle of the module casing 14 in the length direction, inside the bottom face (inside the bottom plate portion 14b) thereof, the tilt drive housing portion 17 that houses the tilt drive portion 21. Therefore, the disposition of the solar cells 15 and the mount board 15b is restricted in a region of the bottom plate portion 14b corresponding to the tilt drive housing portion 17.

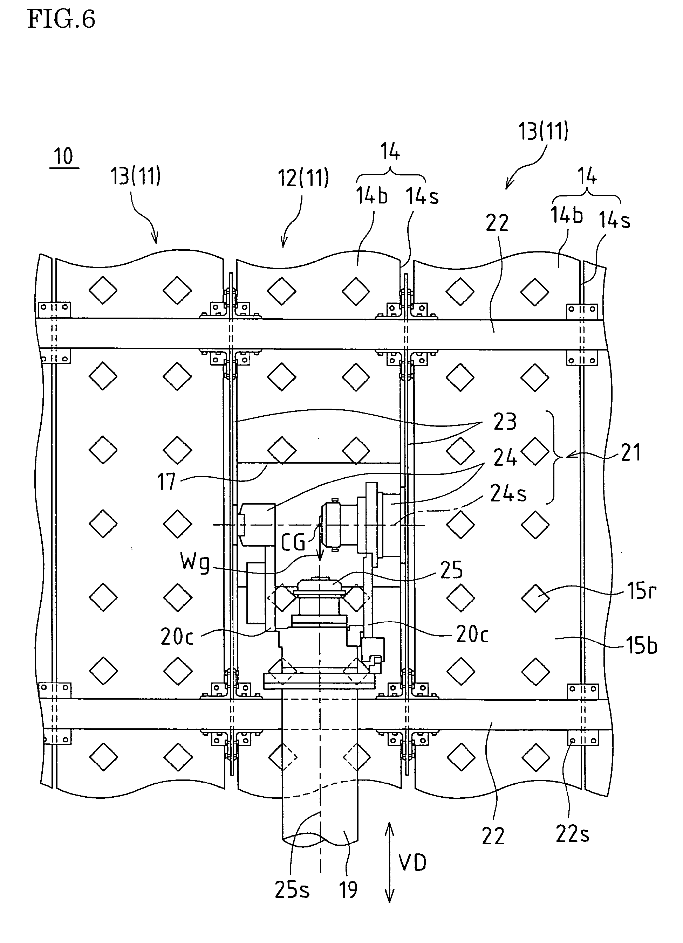

That is to say, in a region corresponding to the condenser lenses 32s located in the middle of the middle condenser lens group 32g, no solar cell 15 and no mount board 15b are disposed, and instead, the tilt drive portion 21 is disposed (see Fig. 6). However, since it is possible to dispose eight solar cells 15 for a single translucent protective plate 31, the reduction in the arrangement density of the solar cells 15 can be minimized.

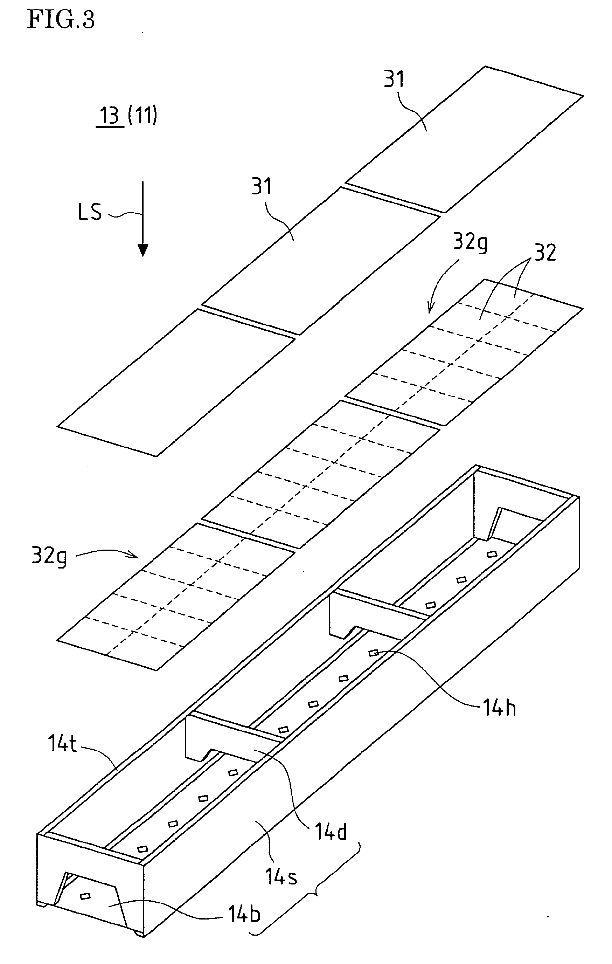

Fig. 3 is an exploded perspective view showing a juxtaposition solar cell module constituting the module panel of the tracking drive type solar power generation apparatus according to Embodiment 1 of the present invention in an exploded manner.

Since the configuration of each juxtaposition solar cell module 13 is basically the same as the configuration of the driving solar cell module 12, differences will be mainly described.

The juxtaposition solar cell modules 13 are different from the driving solar cell module 12 in that the tilt drive housing portion 17 is not provided. Since the juxtaposition solar cell modules 13 do not have the tilt drive housing portion 17, ten solar cells 15 can be disposed in a region of the bottom plate portion 14b corresponding to the middle condenser lens group 32g of the three condenser lens groups 32g as in other regions of the bottom plate portion 14b corresponding to the other two condenser lens groups 32g. Therefore, the arrangement density of the solar cells 15 can be maximized in the juxtaposition solar cell modules 13. Descriptions of the other matters will be omitted.

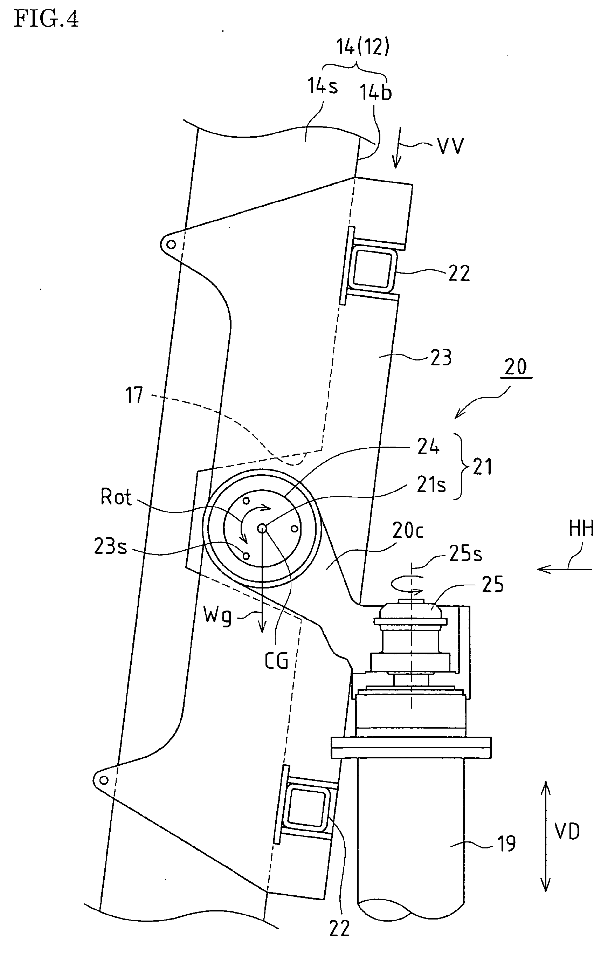

Fig. 4 is a schematic side view conceptually showing the tilt drive portion and the swivel drive portion that constitute the tracking control portion of the tracking drive type solar power generation apparatus according to Embodiment 1 of the present invention as viewed from a lateral side.

Fig. 5 is a schematic plan view conceptually showing a positional relationship between the driving solar cell module and the juxtaposition solar cell modules around the tilt drive portion shown in Fig. 4, as viewed from the direction of arrow VV of Fig. 4.

Fig. 6 is a schematic rear view conceptually showing the positional relationship between the driving solar cell module and the juxtaposition solar cell modules around the tilt drive portion shown in Fig. 4, as viewed from the direction of arrow HH of Fig. 4.

As described above, the tracking control portion 20 includes the tilt drive portion 21 and the swivel drive portion 25. The tilt drive portion 21 and the swivel drive portion 25 are installed on an integral tracking control base 20c. The tracking control base 20c is installed on the top face (the flange face) of the support pole 19. That is to say, the tracking control portion 20 includes the tracking control base 20c to which the tilt drive portion 21 and the swivel drive portion 25 are integrally connected.

With this configuration, the tilt drive portion 21 and the swivel drive portion 25 can be integrated into a single unit, so that the tracking control portion 20 can have a smaller, simplified, and higher-precision structure, facilitating assembly to the module panel 10 and the support pole 19. Thus, the cost and installation man-hours of the tracking control portion 20 can be reduced and an inexpensive tracking drive type solar power generation apparatus 1 having excellent reliability and operating efficiency can be provided.

The driving solar cell module 12 includes the tilt drive housing portion 17 in the middle thereof in the length direction, inside the bottom plate portion 14b (inside the module casing 14) thereof. The tilt drive portion 21 is housed in the tilt drive housing portion 17. Therefore, a tilt rotation axis 21s, which is the center of rotation of the tilt drive portion 21, can be disposed on the same side with respect to the bottom plate portion 14b as the center of gravity CG of the driving solar cell module 12.

That is to say, the tilt drive portion 21 is configured so as to rotate the module panel 10 in the direction of arrow Rot (Fig. 4) around the tilt rotation axis 21s (the center of rotation of a rotary driver 24) that is disposed on the same side with respect to the bottom plate portions 14b of the module panel 10 (the solar cell modules 11) as the center of gravity CG of the module panel 10 (the solar cell modules 11). The rotary driver 24 is constituted by a worm reducer.

Therefore, the tilt rotation axis 21s can be positioned closer to the center of gravity CG of the module panel 10 with respect to the bottom plate portions 14b of the module panel 10, and accordingly, the driving torque that is necessary in controlling the tilt position of the module panel 10 can be reduced, making it possible to reduce the size, power consumption, and cost of the tilt drive portion 21 and provide an inexpensive tracking drive type solar power generation apparatus 1 having excellent reliability and operating efficiency.

Desirably, the tilt rotation axis 21s is positioned so as to coincide with the center of gravity CG of the module panel 10. With this configuration, the gravity Wg acting on the center of gravity CG simultaneously acts on the tilt rotation axis 21s, and therefore, a rotating force due to the gravity Wg is not exerted on the tilt rotation axis 21s (the tilt drive portion 21). Accordingly, the driving torque that is necessary for controlling of the tilt position can be minimized, and the reliability and the operation efficiency can be improved even more.

As described above, since the tilt drive portion 21 employs the center of rotation of the rotary driver 24 as the tilt rotation axis 21s as it is, the need for a power cylinder, which has conventionally been required, can be eliminated, and the tilt drive portion can be constituted by a worm reducer.

The rotary driver 24 is connected to a connecting plate 23 via connecting members 23s. Therefore, rotation of the rotary driver 24 (rotation in the direction of arrow Rot) directly rotates the connecting plate 23. Moreover, a pair of connecting plates 23 are disposed corresponding to the side plate portions 14s, and the pair of connecting plates 23 are connected to each other by the two main beam members 22. Therefore, the tilt position of the main beam members 22 is controlled with rotation of the connecting plates 23.

Moreover, the swivel drive portion 25 controls the swivel position of the module panel 10 around a swivel rotation axis 25s serving as the center of rotation. The swivel rotation axis 25s (a worm reducer) is disposed so as to coincide with the center of an axis of the support pole 19. That is to say, in the present embodiment, the tilt drive portion 21 and the swivel drive portion 25 can have similar driving mechanisms, and thus, the tracking control portion 20 can be configured easily and with high precision.

The main beam members 22 support the module casings 14 (the bottom plate portions 14b). The main beam members 22 fix and support the bottom plate portions 14b of the module panel 10 (the driving solar cell module 12 and the juxtaposition solar cell modules 13, or in other words, the solar cell modules 11) via connecting members 22s (see Fig. 6). Therefore, the tilt position of the solar cell modules 11 (i.e., the module panel 10) can be controlled by controlling the tilt position of the main beam members 22.

As described above, the module panel 10 includes the driving solar cell module 12, the elongated juxtaposition solar cell modules 13 that are disposed on both sides of the driving solar cell module 12, and the main beam members 22 that support the bottom plate portions 14b of the driving solar cell module 12 and the juxtaposition solar cell modules 13, and the driving solar cell module 12 includes, in the middle thereof in the length direction, inside the bottom plate portion 14b thereof, the tilt drive housing portion 17 in which the tilt drive portion 21 is housed.

Therefore, positioning of the tilt rotation axis 21s with respect to the center of gravity CG of the module panel 10 can be performed easily and with high accuracy and the tilt drive portion 21 protected by the tilt drive housing portion 17, so that a load due to the module panel 10 can be applied to the tilt drive portion 21 in a balanced manner, making the tilt drive portion 21 capable of performing tilt control easily and with high accuracy and hence highly reliable.

The tilt drive portion 21 includes the pair of connecting plates 23 (see Figs. 5 and 6) that are connected to each other by the two main beam members 22 and disposed corresponding to the side plate portions 14s in the length direction of the juxtaposition solar cell modules 13, and the rotary driver 24 that is disposed between the connecting plates 23 and between the main beam members 22 and fixed to the connecting plates 23 and that rotates the connecting plates 23 around the tilt rotation axis 21s.

Therefore, the tilt drive portion 21 rotates the connecting plates 23 easily and with high accuracy to tilt the pair of main beam members 22 easily and with high accuracy, and so the tilt position of the module panel 10 can be controlled easily and with high accuracy. That is to say, the tilt drive portion 21 can be mechanically stable with a simple structure and hence highly reliable.

The mount board 15b on which the solar cells 15 are mounted is disposed on a rear face (a back face, that is, the bottom plate portion 14b) of the module casing 14. Moreover, heat release members 15r (see Fig. 7) corresponding to the respective solar cells 15 are disposed on a back face of the mount board 15b. It should be noted that the heat release members 15r are omitted from Figs. 4 and 5 in view of the clarity of the drawings.

Adjacent juxtaposition solar cell modules 13 can be fixed to each other by suitable connecting means. Fixing the juxtaposition solar cell modules 13 to each other makes it possible to determine the positions of the solar cells 15 with high accuracy, and thus, the module panel 10 can be structurally stable.

Fig. 7 is a schematic end view conceptually showing a positional relationship between the solar cells disposed in the solar cell module shown in Fig. 6 and the module casing as viewed from a direction intersecting with the main beam members. Hatching in end faces is omitted in view of the clarity of the drawing.

The module casing 14 includes the side plate portions 14s and the bottom plate portion 14b, and the bottom plate portion 14b is connected to the main beam members 22 via the connecting members 22s. The mount board 15b on which the solar cells 15 arranged in two rows are mounted is attached to the rear face of the bottom plate portion 14b. Sunlight LS that has been concentrated via the translucent protective plate 31 and the condenser lenses 32 is irradiated onto the solar cells 15 via the sunlight transmission holes 14h. Since sunlight LS is irradiated onto the solar cells 15 only via the sunlight transmission holes 14h, the surface of the mount board 15b is not exposed to unwanted sunlight LS.

The heat release members 15r are provided in positions corresponding to the respective solar cells 15 on the rear face of the mount board 15b. Therefore, solar heat generated by the sunlight LS irradiated onto the solar cells 15 can be released to the outside of the solar cell module 11 (the module casing 14), and thus a high power generation efficiency can be realized.

It should be noted that the solar cells 15 are configured as concentrating solar cells that perform photoelectric conversion on sunlight LS that has been concentrated by the condenser lenses 32, and therefore, a tracking operation of the tracking drive type solar power generation apparatus 1 by the tracking control portion 20 can be made more effective. That is to say, since the module panel 10 always receives sunlight LS from the front, it is possible to concentrate sunlight LS easily and with high accuracy and irradiate high-energy sunlight LS onto the solar cells 15, thereby realizing a high power generation efficiency and generating stable and high output power.

A region near the middle of the bottom plate portion 14b and exclusive of its ends is bent to the top portion 14t side, so that the mount board 15b with the solar cells 15 mounted thereon can be disposed closer to the top portion 14t than the bottom face defined by the bottom plate portion 14b. Therefore, even when the mount board 15b is provided with the heat release members 15r, the center of gravity CG of the solar cell modules 11 (the module panel 10) can be located further inside (on the top portion 14t side of the bottom plate portion 14b) of the module casing 14 than the bottom plate portion 14b.

### Embodiment 2

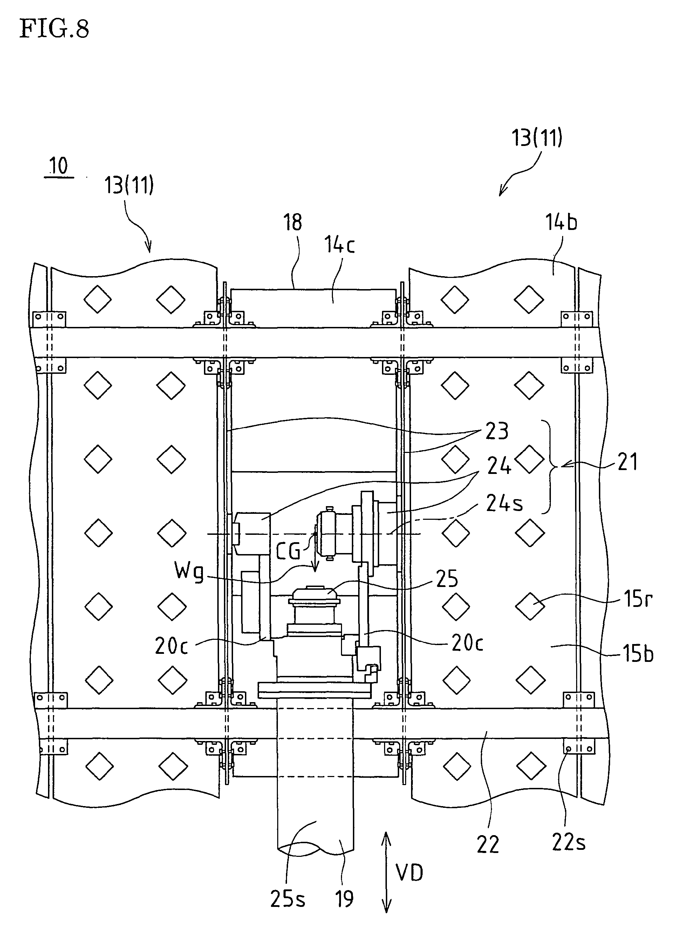

A tracking drive type solar power generation apparatus according to the present embodiment will be described based on Fig. 8.

Fig. 8 is a schematic rear view showing a positional relationship of solar cell modules of a tracking drive type solar power generation apparatus according to Embodiment 2 of the present invention as compared with that in the case of Fig. 6.

The driving solar cell module 12 adopted in Embodiment 1 is excluded from a module panel 10 according to the present embodiment. That is to say, a so-called butterfly-shaped module array is employed in which juxtaposition solar cell modules 13 are disposed separately on the right side and the left side. The other configurations are basically the same as those of Embodiment 1, and so differences will be mainly described.

In a tracking drive type solar power generation apparatus 1 according to the present embodiment, the module panel 10 includes a tilt drive disposition portion 18 in which a tilt drive portion 21 is located in the middle of the module panel 10 in the horizontal direction, the elongated juxtaposition solar cell modules 13 disposed on both sides of the tilt drive disposition portion 18, and main beam members 22 that support bottom plate portions 14b of the juxtaposition solar cell modules 13.

Therefore, the tilt drive portion 21 can be positioned easily and with high accuracy, so that a load due to the module panel 10 can be applied to the tilt drive portion 21 in a balanced manner, making the tilt drive portion 21 capable of performing tilt control easily and with high accuracy and hence highly reliable. Moreover, the tilt drive portion 21 can be easily exposed, so that maintenance of the tilt drive portion 21 can be easily carried out.

The juxtaposition solar cell modules 13 with respect to the main beam members 22, the tilt drive portion 21, the main beam members 22, and connecting plates 23 can take the same forms as those of Embodiment 1.

It should be noted that a covering portion 14c that functions in the same manner as the tilt drive housing portion 17 (Embodiment 1) may be provided in the tilt drive disposition portion 18 by processing the module casing 14 of the driving solar cell module 12 (Embodiment 1). The provided covering portion 14c can protect the tilt drive portion 21 from the external environment.

### Embodiment 3

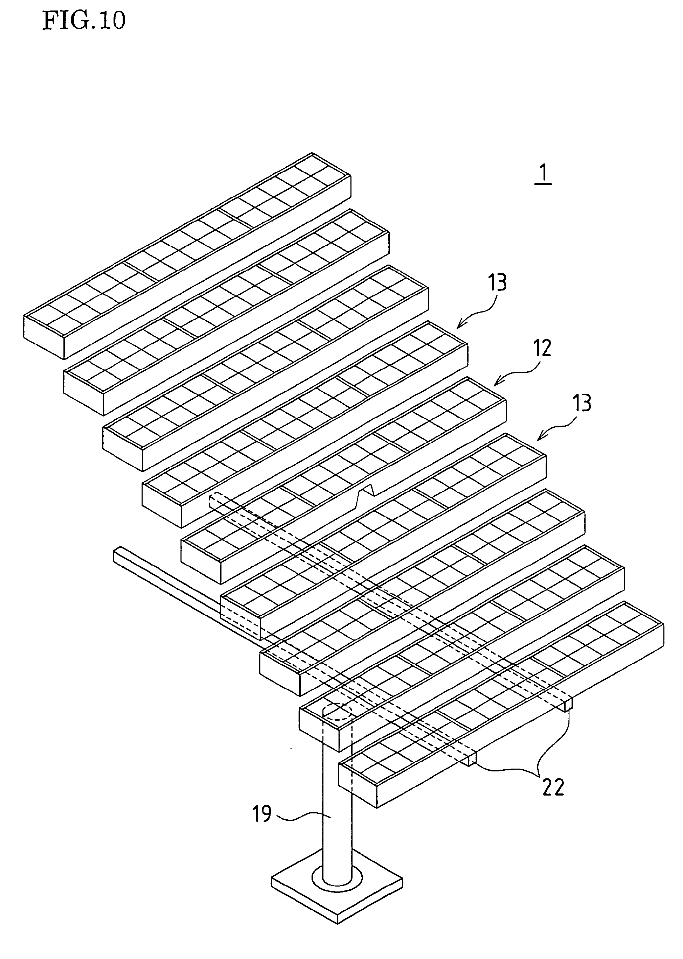

An assembly process of a tracking drive type solar power generation apparatus according to the present embodiment will be described based on Figs. 9(A) to 9(E) and Fig. 10.

Figs. 9(A) to 9(E) illustrate an assembly process of a juxtaposition solar cell module and a module casing according to Embodiment 3 of the present invention by means of perspective views, where Fig. 9(A) shows side plate portions and a bottom plate portion that have been prepared, Fig. 9(B) shows a frame formed by connecting the side plate portions to the bottom plate portion, Fig. 9(C) shows a state in which partition plates have been connected to the frame, Fig. 9(D) shows a state in which sealing plates have been attached to both ends of the frame, and Fig. 9(E) shows a state in which translucent protective plates and condenser lenses have been disposed on the top of the side plate portions.

A module casing 14 constituting the structure of a juxtaposition solar cell module 13 (a solar cell module 11) according to the present embodiment includes elongated side plate portions 14s and bottom plate portion 14b formed of, for example, a steel plate. That is to say, a frame 14f of the juxtaposition solar cell module 13 is constituted by the two side plate portions 14s facing each other and the bottom plate portion 14b that connects bottom faces of the two side plate portions 14s to each other (Figs. 9(A) and 9(B)). Sunlight transmission holes 14h for transmitting and irradiating concentrated sunlight LS onto respective solar cells 15 are formed in the bottom plate portion 14b.

The frame 14f is partitioned into three regions, and partition plates 14d are provided on the borders between the regions. Mechanical strength and dimension accuracy of the frame 14f are improved by providing the partition plates 14d (Fig. 9(C)). Moreover, sealing plates 14w are disposed at both ends of the frame 14f (Fig. 9(D)) to protect the interior of the module casing 14 from the external environment. The sealing plates 14w can have a suitable vent.

Three each of translucent protective plates 31 and condenser lens groups 32g corresponding to the three regions are disposed on a top portion 14t of the module casing 14, and ends of the translucent protective plates 31 and the condenser lens groups 32g are supported and fixed by the partition plates 14d and the top portion 14t. Therefore, mechanical strength and position accuracy of the translucent protective plates 31 and the condenser lens groups 32g can be secured.

The juxtaposition solar cell module 13 can be assembled through the process shown in Figs. 9(A) to 9(E).

It should be noted that the driving solar cell module 12 is different from the juxtaposition solar cell module 13 in that the tilt drive housing portion 17 (see Fig. 1) that houses the tilt drive portion 21 is disposed in the middle of the driving solar cell module in the length direction, inside the bottom face (inside the bottom portion 14b) thereof. Regarding the other configurations, the driving solar cell module 12 and the juxtaposition solar cell module 13 can be formed in the same manner.

Fig. 10 is an exploded perspective view showing the tracking drive type solar power generation apparatus according to Embodiment 3 of the present invention in an exploded manner.

In a tracking drive type solar power generation apparatus 1 according to the present embodiment, the driving solar cell module 12 is disposed in the middle, and the juxtaposition solar cell modules 13 are disposed on both sides thereof. Moreover, rear faces (the bottom plate portions 14b) of the driving solar cell module 12 and the juxtaposition solar cell modules 13 are supported by main beam members 22. Furthermore, the main beam members 22 are held by a support pole 19 via a tracking control portion 20 (herein omitted from the drawing in view of the clarity of the drawing; see Fig. 1).

It should be noted that the tracking drive type solar power generation apparatus 1 can be assembled through an assembly process below.

The tracking control portion 20 is installed on a flange face of the support pole 19. In the tracking control portion 20, a tilt drive portion 21 and a swivel drive portion 25 are assembled to a tracking control base 20c beforehand. Moreover, connecting plates 23 are attached to the tilt drive portion 21 beforehand.

Next, the main beam members 22 are attached to the connecting plates 23, and the driving solar cell module 12 and the juxtaposition solar cell modules 13 are placed on the main beam members 22. The tracking drive type solar power generation apparatus 1 can be assembled through the above-described process.

### Embodiment 4

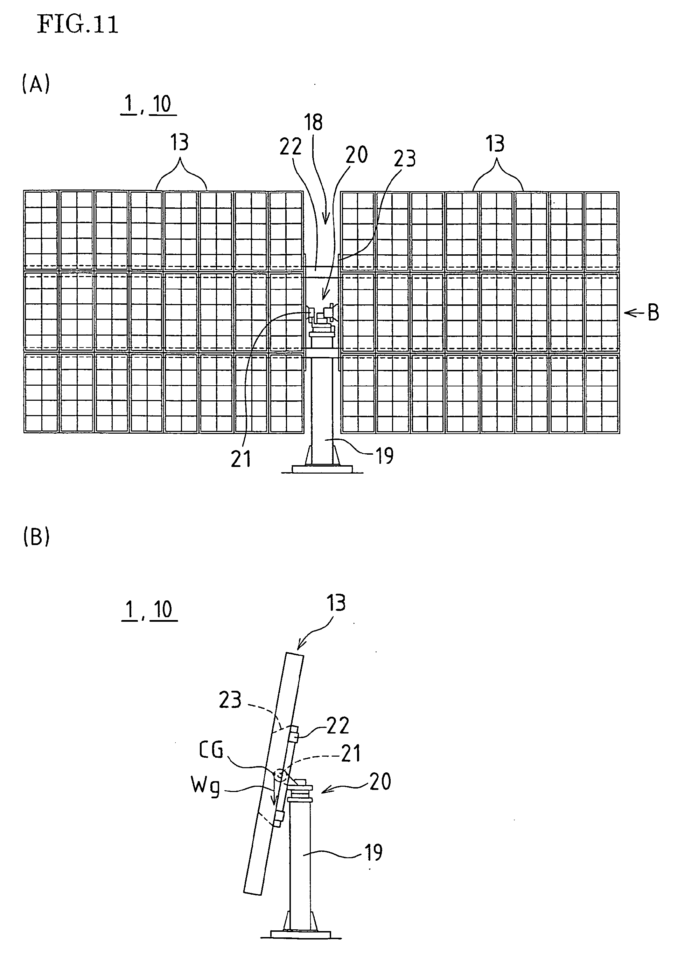

A tracking drive type solar power generation apparatus according to the present embodiment will be described based on Figs. 11(A) and 11(B).

Figs. 11(A) and 11(B) are external views schematically showing an appearance of a tracking drive type solar power generation apparatus according to Embodiment 4 of the present invention, where Fig. 11(A) is a front view, and Fig. 11(B) is a side view as viewed from the direction of arrow B of Fig. 11(A).

A basic configuration of a tracking drive type solar power generation apparatus 1 according to the present embodiment is the same as those of the tracking drive type solar power generation apparatuses 1 shown in Embodiments 1 to 3, and will be described by taking the reference numerals from those embodiments as necessary.

In the tracking drive type solar power generation apparatus 1 (a module panel 10) according to the present embodiment, a tracking control portion 20 attached to a support pole 19 is disposed in a tilt drive disposition portion 18 in the middle, and thus, juxtaposition solar cell modules 13 are disposed separately on the right side and the left side. That is to say, the juxtaposition solar cell modules 13 are symmetrically arranged on the right side and the left side, and a butterfly-shaped module array is employed as in Embodiment 2.

Eight each juxtaposition solar cell modules 13 are disposed on the right side and the left side and placed on and fixed by two main beam members 22 that are connected to connecting plates 23 of the tracking control portion 20 (the tilt drive portion 21) and disposed so as to extend in the horizontal direction.

It should be noted that although the covering portion 14c with which the tilt drive portion 21 is covered is provided in the module panel 10 shown in Embodiment 2, the covering portion 14c is omitted and the tracking control portion 20 is exposed in the present embodiment. Therefore, maintenance of the tracking control portion 20 can be easily carried out.

### Variation of Embodiment 4

Moreover, when the tilt drive portion 21 is installed near a rotation axis of the swivel drive portion 25 installed on a top face (a flange face) of the support pole 19, the center of gravity of the module panel can be close to the swivel rotation axis, and the driving torque that is necessary in controlling the swivel position of the module panel can be reduced, so that it is possible to obtain an effect that the size, power consumption, and cost of the swivel drive portion can be reduced and an inexpensive tracking drive type solar power generation apparatus having excellent reliability and operating efficiency can be provided.

Moreover, when the tilt drive portion 21 is installed near the rotation axis of the swivel drive portion 25, the center of gravity of the module panel and an axis of the support pole 19 are close to each other, so that the required strength of the tracking control base 20c can be decreased, and a mechanically stable, highly reliable tracking control portion can be configured.

It should be noted that a module panel 10 in which juxtaposition solar cell modules 13 are disposed separately on the right side and the left side as shown in Embodiment 4 has a structure suited to install the tilt drive portion 21 near the rotation axis of the swivel drive portion 25 installed on the top face (the flange face) of the support pole 19.

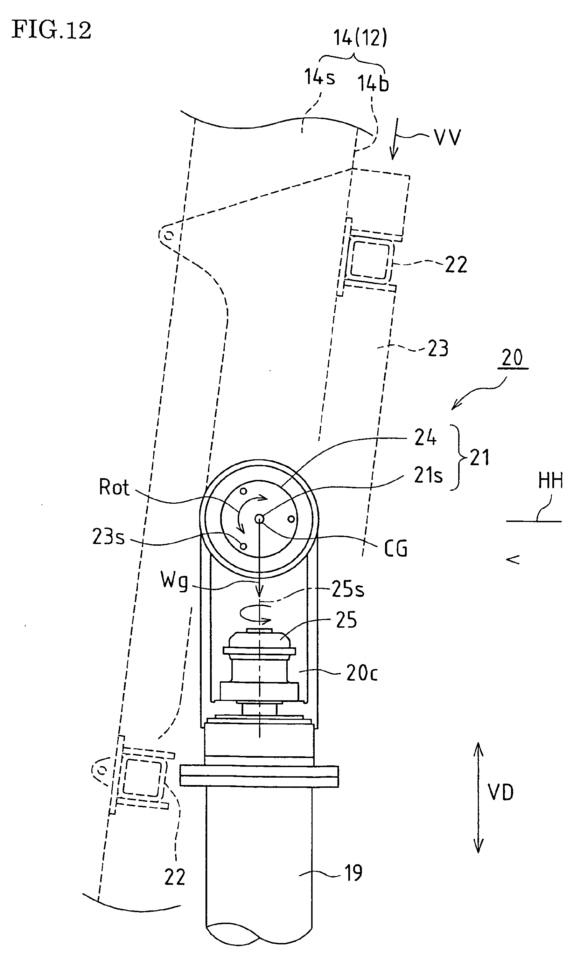

As an example in which the tilt drive portion 21 is installed near the rotation axis of the swivel drive portion 25, Fig. 12 shows an embodiment in the case where the rotation axis of the swivel drive portion 25 and the rotation axis of the tilt drive portion 21 intersect.

Moreover, in the case where the support pole 19 and the main beam member 22 overlap as shown in Fig. 12, for example, the lower main beam member 22 can be bent to the condenser lens side in such a manner that the main beam member detour around the support pole.

Moreover, in the case where it is necessary to save the module panel from wind pressure in strong winds, for example, and other cases, when the module panel is kept at rest in a nearly horizontal position, when the center of gravity of the module panel and the axis of the support pole 19 are close to each other, it is possible to obtain an effect that a mechanically stable tracking drive type solar power generation apparatus can be provided.

The present invention may be embodied in various other forms without departing from the spirit or essential characteristics thereof. Accordingly, the above-described embodiments are to be considered in all respects as illustrative and not limiting. The scope of the invention is indicated by the appended claims rather than by the foregoing description. Furthermore, all variations and modifications falling within the meaning and range of equivalency of the appended claims are intended to be embraced within the scope of the invention.

It should be noted that this application claims priority on Patent Application No. 2008-107997 filed in Japan on April 17, 2008, the entire contents of which are herein incorporated by reference. Moreover, all documents cited in this specification are herein specifically incorporated by reference.

### Description of Reference Numerals

- 1: Tracking drive type solar power generation apparatus
- 10: Module panel
- 11: Solar cell module
- 12: Driving solar cell module
- 13: Juxtaposition solar cell module
- 14: Module casing
- 14b: Bottom plate portion
- 14c: Covering portion
- 14d: Partition plate
- 14f: Frame
- 14h: Sunlight transmission hole
- 14s: Side plate portion
- 14t: Top portion
- 14w: Sealing plate
- 15: Solar cell
- 15b: Mount board
- 15r: Heat release member
- 17: Tilt drive housing portion
- 18: Tilt drive disposition portion
- 19: Support pole
- 20: Tracking control portion
- 20c: Tracking control base
- 21: Tilt drive portion
- 21s: Tilt rotation axis
- 22: Main beam member
- 22s: Connecting member
- 23: Connecting plate
- 23s: Connecting member
- 24: Rotary driver
- 25: Swivel drive portion
- 25s: Swivel rotation axis
- 31: Translucent protective plate
- 32: Condenser lens
- 32g: Condenser lens group
- CG: Center of gravity
- LS: Sunlight
- HD: Horizontal direction
- VD: Vertical direction
- Wg: Gravity

## Claims

1. A tracking drive type solar power generation apparatus comprising:
a module panel in which solar cells are arranged and
a tracking control portion that drives the module panel to track the sun,
wherein the tracking control portion comprises
a tilt drive portion that controls a tilt position of the module panel and
a swivel drive portion that controls a swivel position of the module panel, and
the tilt drive portion rotates the module panel around a tilt rotation axis that is disposed on the same side with respect to a bottom plate portion of the module panel as a center of gravity of the module panel.

2. The tracking drive type solar power generation apparatus according to claim 1,
wherein the tilt rotation axis is positioned so as to coincide with the center of gravity of the module panel.

3. The tracking drive type solar power generation apparatus according to claim 1 or 2,
wherein the tracking control portion comprises a tracking control base to which the tilt drive portion and the swivel drive portion are integrally connected.

4. The tracking drive type solar power generation apparatus according to claim 1 or 2,
wherein the module panel comprises
an elongated driving solar cell module that is disposed in a middle of the module panel in a horizontal direction,
elongated juxtaposition solar cell modules that are disposed on both sides of the driving solar cell module, and
main beam members that support bottom plate portions of the driving solar cell module and the juxtaposition solar cell modules, and
the driving solar cell module comprises, in a middle of a module casing in a length direction, inside a bottom face thereof, a tilt drive housing portion in which the tilt drive portion is housed.

5. The tracking drive type solar power generation apparatus according to claim 1 or 2,
wherein the module panel comprises
a tilt drive disposition portion in which the tilt drive portion is located in a middle of the module panel in a horizontal direction,
elongated juxtaposition solar cell modules that are disposed on both sides of the tilt drive disposition portion, and
main beam members that support bottom plate portions of the juxtaposition solar cell modules.

6. The tracking drive type solar power generation apparatus according to claim 4,
wherein the tilt drive portion comprises
a pair of connecting plates that are connected to each other by the two main beam members and disposed corresponding to side plate portions in a length direction of the juxtaposition solar cell modules, and
a rotary driver that is disposed between the connecting plates and between the main beam members and fixed to the connecting plates and that rotates the connecting plates around the tilt rotation axis.

7. The tracking drive type solar power generation apparatus according to claim 5,
wherein the tilt drive portion comprises
a pair of connecting plates that are connected to each other by the two main beam members and disposed corresponding to side plate portions in a length direction of the juxtaposition solar cell modules, and
a rotary driver that is disposed between the connecting plates and between the main beam members and fixed to the connecting plates and that rotates the connecting plates around the tilt rotation axis.
